# EUROPEAN PATENT SPECIFICATION

(11) **EP 0 424 009 B1**
(45) Date of publication and mention of the grant of the patent: **06.03.1996**
(21) Application number: 90311062.5
(22) Date of filing: 09.10.1990
(51) Int. Cl.: H04B 1/16, H03G 3/00, H03G 3/20, H04M 1/60

(54) **Automatic gain control circuit in a radio telephone receiver**
Automatische Verstärkungsregelungsschaltung für Funktelefonempfänger
Circuit de commande automatique de gain pour récepteur radio-téléphonique

(30) Priority: 18.10.1989 FI 894966
(43) Date of publication of application: 24.04.1991
(73) Proprietor: NOKIA MOBILE PHONES LTD., SF-24101 Salo (FI)
(72) Inventor: Vaisanen, Risto, SF-24100 Salo (FI)
(74) Representative: Adams, William Gordon

(56) References cited:
- GB-A- 2 161 335
- US-A- 4 792 991

## Description

The present invention concerns automatic gain control in a receiver for a digital radio telephone in which the received signal is amplified with an RF amplifier, transmitted to a first intermediate frequency in a first mixer, potentially to a second intermediate frequency in a second mixer, and is thereafter conducted to two branches in which the base band frequency I and Q signals are produced.

In digital radio telephones, e.g. in GSM radio telephones, automatic gain control is used to maintain the level of the received signal in a constant value prior to AD converters.

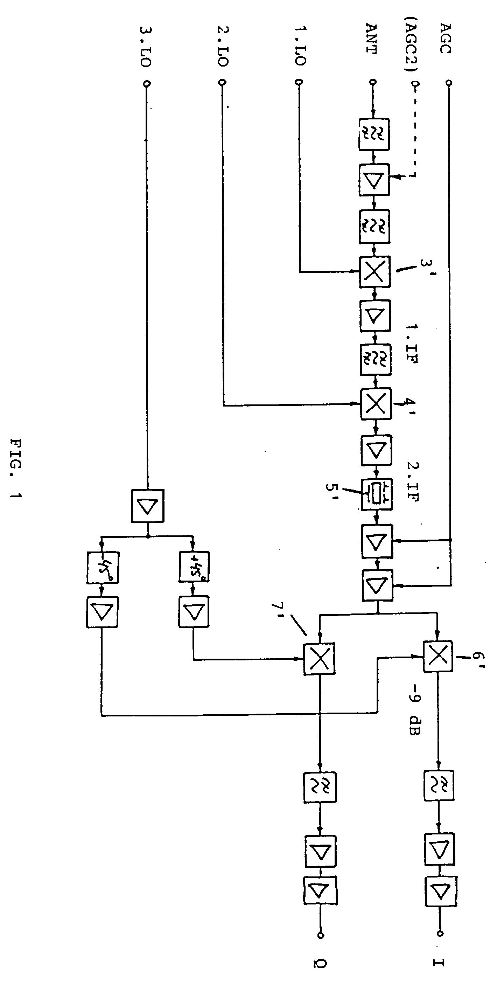

The most common way is to accomplish the AGC function similarly as in AM or SSB receivers wherein the AGC is implemented using as an IF amplifier a voltage controlled amplifier controlled with analog voltage, said amplifier attenuating the signal the more the higher its amplitude. In said manner known in the art part of the AGC function can be placed in the first stages of the receiver. Examples of applying the AM or SSB receiver principles in the GSM radio telephone receiver is the block diagram typical of a GSM radio telephone receiver presented in Fig. 1. A radio frequency signal from the antenna is filtered and amplified with an amplifier, this being possibly part of the AGC function, and mixed in a mixer 3′ into a frequency of a first local oscillator. The produced mixing results are amplified and the signal filtered therefrom is taken to a second mixer 4′ in which it is mixed into a second local oscillator frequency. The obtained mixing result is filtered using a filter 5′ and is taken to two consecutive amplifier stages, the gain thereof being controlled with a voltage from the D/A converter of the logic section, and the AGC function being thus implemented. After the AGC amplifiers, the signal path is divided into two branches in which the I signals and the Q signals are produced by mixing in the mixers 6', and 7', the signal frequencies with a third local oscillator frequency, which is carried to the mixers 90 degree phase shifted relative to one another.

According to the block diagram described above, a receiver can be designed, but a number of deficiencies are associated therewith. The properties of a voltage controlled AGC amplifier located in intermediate frequency stages are in general poor due to the current controlled amplifiers used and the large control range required in the GSM system. The control curve of the AGC amplifier is non-linear and its shape, as well as the amplification of the amplifier, is dependent on temperature. Owing to said properties, great differences exist between different amplifier exemplars, as a result of which the control curve of the amplifier and the dependence of the properties thereof on temperature must for each telephone be tabulated individually or compensated by means of complex analog circuits. The amplification of the AGC amplifier should at maximum gain be great in order not to impair the signal/noise ratio when lowering the amplification. Because of the large amplification, it is, on the other hand, necessary to employ good filtering prior to the AGC amplifier because, otherwise, the signals in the adjacent channels will become too much amplified and cause blockage and an intermodulation phenomenon. A filter presenting good enough characteristics is in general expensive and bulky. Since in a known circuit the frequency of a local oscillator for use in producing I and Q signals is equal to the intermediate frequency, it is in general exceedingly difficult to prevent the local oscillator signal from becoming connected to the intermediate frequency amplifier. Such connection in itself is not objectionable but in the above circuit in which the amplification of the intermediate amplifier in a second intermediate frequency is changed, major problems arise regarding the d.c. voltage levels in the I branches and Q branches. The d.c. voltage levels in both branches are dependent on the gain of the AGC amplifiers at any one moment, and any change in the gain causes a rapid change in d.c. levels, the effect of which cannot be eliminated e.g. by means of an a.c. circuit (capacitors) in the I branch and the Q branch.

The object of the invention is to provide an automatic gain control in a receiver of a radio telephone with which the drawbacks of the circuit of prior art described above can be eliminated.

Said aim is achieved according to claim 1 in that majority of the total gain control of the received signal is carried out in the base band frequency parts, the signal gain in the I branch and Q branch whereof being controlled stepwise, and a minor part of the total gain control is accomplished in the RF stage.

As taught by the invention, majority of the total amplification and the AGC function is placed in the so-called base band frequency sections, that is, in the I and Q branches. The amplifying step desired at each moment is selected using analog multiplexers connecting the selected amplifier step and the selected attenuator stage to the path of the I and Q signals. By controlling the multiplexers, the total of 32 power step combinations is obtained for the I and Q signals. When, moreover, the RF antenna amplifier is arranged to be so adjustable that its gain can be reduced by means of control e.g. 20 dB, the number of amplification steps can, including the above, be increased to be sufficient for the GSM system. The whole of the amplifiers in the I and Q branches and of the attenuator, as well as possibly of the RF amplifier adjustable in two steps, if any, constitute an AGC circuit having as its feedback branch a logic circuit monitoring the level of the outgoing I and Q signals and maintaining them substantially constant independent of the strength of the antenna signal. The logic circuit maintains said level constant in that it controls the multiplexers of the I and Q branches selecting the power step of the amplifiers, and the multiplexers selecting the attenuation rate of the attenuators located in said branches, using digital control, so that independent of the incoming signal the outgoing signal is constant.

The invention is described below more in detail, reference being made to the accompanying figures, wherein
Figure 1 presents a circuit for a radio telephone receiver according to the state of art.
Figure 2 presents the circuit for a radio telephone receiver according to the invention.

The circuit of Fig. 1 is already described above as regards the essential aspects in conjunction with the state of art description, and for that reason it will no longer be described in detail.

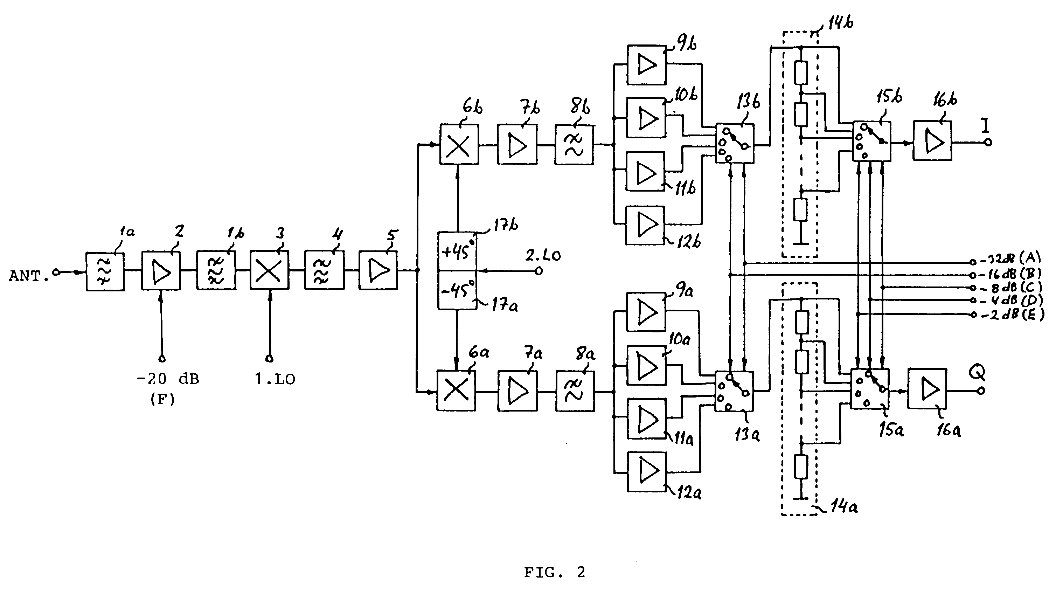

As is shown in Figure 2, a received signal emitted from the antenna is amplified after the filter la in an RF amplifier 2, the gain of which can be reduced by control F, e.g. 20 dB. The signal filtered in the filter 1b is taken to a mixer 3, where the intermediate frequency filtered from the mixing results thereof and of the local oscillator is divided after the intermediate amplifier 5 into two branches for producing I and Q signals. In said branches, the I/Q signals (of sin and cos shape) are produced in the mixers 6a and 6b so that the incoming signal is mixed with the frequency from the second local oscillator in the mixers when the incoming local oscillator frequencies are at 90 degree phase shift to each other. The I/Q signal production is in itself known in the art, and it will not be referred to in the present context. The I and Q signals obtained as mixing results are amplified in amplifiers 7a and 7b, and the high frequencies are filtered from the amplified signals in filters 8a and 8b.

The above description is fairly obvious to a person skilled in the art. The circuit hereinafter contains the very core of the invention. The signal path in both branches is divided into a plurality of branches, each of which being provided with an amplifier 9a, 10a, 11a, 12a; 9b, 10b, 11b, 12b. In multiplexers 13a, 13b one amplifier may in both branches at a time be connected to the signal path, e.g. by a given multiplexer control the signal passes in the I branch through the amplifier 10b and in Q branch, through the amplifier 10a. Said amplifiers have equal gain. Similarly, with different control of the multiplexers 13a, b the signals will pass through other amplifiers, said amplifiers always having the equal gain, two and two, but it is understood that the amplifiers 9a-12a of the Q branch have different gains, as have also the amplifiers 9b-12b of the I branch. The gain of the amplifiers 10a and 10b could be e.g. 50 dB, the gain of the amplifiers 11a and 11b e.g. 18 dB, and the gain of the amplifiers 12a and 12b e.g. 2 dB. The above values are, in fact, gains of said amplifiers. When selecting with a multiplexer a signal of an amplifier branch, a given amplifying step is hereby selected, which means a relative change of the gain. For instance, a signal selected from the 50 dB amplifier corresponds to a 0 dB gain step, that is maximum gain, and e.g. a signal from the 2 dB amplifier corresponds to the -48 dB gain step. Respectively, selecting 34 dB and 18 dB amplifiers is equivalent to the gain step -16 dB and -32 dB. Different gains may, of course, be used. The multiplexers are controlled using digital control signals A and B, with which the multiplexer can be directed into four different positions. The control signals are obtained from the logic circuit of the telephone which is monitoring the signal level prior to the AD converters.

In the manner described above, great gain steps can be produced. Small gain steps may be produced, as taught by the invention, so that the signal route is after the amplifiers provided with an attenuator in both branches, most preferably a resistance attenuator composed of similar resistance network 14a and 14b, among which a signal of desired size is selected by multiplexers 15a and 15b. Said multiplexers obtain also the control from the control logic of the telephone. With three control signals C, D and E, one out of eight relative gain steps can be selected, and said steps may be for instance 0 dB, -2 dB, -4 dB, -8 dB, -10 dB, -12 dB, and -14 dB. A given control signal combination C, D and E produces an amplification step of equal magnitude from the attenuators 14a and 14b. After the attenuators 14a and 14b, the signals propagate through the amplifiers 16a and 16b to the output of the circuit. The gain of the amplifiers 16a and 16b could be e.g. 15 dB.

By controlling the multiplexers 13a, 13b, and 15a, 15b, altogether 32 different amplification step combinations can be obtained. The range may be further expanded by making the RF amplification 2 so controllable that its gain can be reduced by means of the logic control F e.g. in the amount of 20 dB. Hereby, for instance an 84 dB power range can be covered with control signals A, B, C, D, E, F at 2 dB intervals. In the GSM system, this is quite sufficient.

In the foregoing, an AGC amplifier circuit placed in the base band frequency parts is introduced. An AGC amplifier circuit placed in the base band frequency sections is in principle implementable in a remarkably simpler way by placing in the base band frequency section in succession logic-controlled amplifier/attenuator stages, the amplifying or attenuating steps thereof would be in 2, 4, 8, 16, 32 dB (and a 20 dB attenuation in the RF part). This has not, however, proved to be possible in practice because the multiplexer or the analog switch causes a brief but strong, e.g. 100 mV, peak-switching voltage in the signal path, which is amplified in the amplifier chain e.g. 60 dB being cut, and causes shifting of DC levels. Another problem is related to change of DC levels caused by the offset voltages of the operational amplifiers conforming to the selected gain, if for the gain control system to select e.g. feedback gains in the operational amplifiers is used with the aid of analog switches. In the circuit of the invention, the effect of the circuit peaks has been eliminated by dividing the signal first into four branches, and by amplifying the level of each branch to correspond to the desired amplification step. The level of the signal selected with the multiplexer 13a and 13b is of equal magnitude as in the level of the circuit peak; therefore, the circuit peak causes no harm. The effect of the offset voltages can be eliminated using an AC circuit (capacitors) before the multiplexers. The smallest amplification steps may thereafter be produced by selecting from the resistance attenuator 14a, 14b a signal of the desired level using the multiplexer 15a, 15b.

With the circuit of the invention, an AGC system of a digital radio telephone receiver is produced with which all amplification steps required in the GSM telephone can be produced without any drawbacks caused by the circuit peaks and changes of DC levels, and without the drawbacks which the AGC function placed in the intermediate frequency stages causes. The amplification steps are precise, and they are not dependent on temperature. Since most part of the gain and of the AGC function can be placed in the base band frequency parts, the gain of the RF stages and the intermediate frequency stages can be set to be considerably small (e.g. amounting to 20 dB), and consequently, a very simple and inexpensive filter can be used. The entire receiver can be made such that it occupies a very small space because most of the gain and the AGC function are placed in the base band frequency sections, which may be entirely integrated on silicon. The intermediate frequency sections have no gain control associated with the AGC; therefore, connecting a signal from the local oscillator to the intermediate frequency stages is not objectionable. In other words, the DC voltage levels of the I and Q branches do not vary because of the local oscillator signal connected to the intermediate frequency stages.

Maintaining within the protective scope of the claims, the circuit is implementable in practice in a plurality of ways. Thus, for instance, more than four amplifiers may be provided, and the attenuator can be other than the resistance network.

## Claims

1. A circuit for a receiver of a digital radio telephone, said circuit including:
an RF amplifier (2) for receiving and amplifying an RF signal,
means (3, 4, 5) including at least one mixer (3) for transferring the amplified RF signal to an intermediate frequency signal, and
an I branch (6b, 7b, 8b, 16b) and a Q branch (6a, 7a, 8a, 16a) each coupled to receive the intermediate signal for producing base band signals I and Q respectively,
characterised in that a first part (9a - 15a; 9b - 15b) of an automatic gain control circuit is included in the I and Q branches for carrying out most of the total gain control on the base band I and Q signals, the amplification of the base band I and Q signals being controllable in steps by means of digital control signals (A, B, C, D, E), and a second part of the automatic gain control circuit is included in the RF amplifier (2).

2. A circuit according to claim 1, wherein, for providing said steps of amplification, each of said I and Q branches includes
(a) a respective plurality of sub-branches each containing an amplifier (9a - 12a; 9b - 12b) having a different predetermined gain, and
(b) a first multiplexer (13a, 13b) which is controllable by first ones (A, B) of said digital control signals for selecting the sub-branch containing the amplifier having a desired gain.

3. A circuit according to claim 2, wherein each of said I and Q branches further comprises a respective attenuator (14a, 14b) providing paths of different attenuation, one path of which may provide direct coupling, and a respective second multiplexer (15a, 15b), said attenuator being coupled between the output of said first multiplexer and inputs of said second multiplexer, the latter being controllable by second ones (C, D, E) of said digital control signals for further stepwise control of the amplification of the base band I and Q signals.

4. A circuit according to claim 3 wherein said attenuator (14a, 14b) is a resistance network.

5. A circuit according to any preceding claim, wherein the RF amplifier has two levels of amplification, and the desired level is selectable by means of a third digital control signal (F).

6. A circuit according to claim 5 as dependent on claim 3 or claim 4, wherein the entire gain control range of the receiver is covered step by step by different combinations of the digital control signals (A - F) applied to the first and second multiplexers (13a, 13b; 15a, 15b) and the RF amplifier (2).

## Patentansprüche

1. Schaltung für einen Empfänger eines digitalen Funktelefons, die folgendes aufweist:
- einen HF-Verstärker (2) zum Empfangen und Verstärken eines HF-Signals;
- eine Einrichtung (3, 4, 5) mit mindestens einem Mischer (3) zum Umsetzen des verstärkten HF-Signals in ein Zwischenfrequenzsignal; und
- einen Zweig I (6b, 7b, 8b, 16b) und einen Zweig Q (6a, 7a, 8a, 16a), von denen jeder so angeschlossen ist, daß er das Zwischenfrequenzsignal empfängt, um Grundbandsignale I bzw. Q zu erzeugen;
**dadurch gekennzeichnet,** daß ein erster Teil (9a - 15a; 9b - 15b) einer Schaltung für automatische Verstärkungsregelung in den Zweigen I und Q enthalten ist, um den größten Teil der Gesamtverstärkungsregelung hinsichtlich der Grundbandsignale I und Q auszuführen, wobei diese Verstärkung der Grundbandsignale I und Q mittels digitaler Steuersignale (A, B, C, D, E) in Schritten einstellbar ist, und ein zweiter Teil der Schaltung für automatische Verstärkungsregelung im HF-Verstärker (2) enthalten ist.

2. Schaltung nach Anspruch 1, bei der jeder der Zweige I und Q zum Ausführen der Verstärkungsschritte folgendes aufweist
(a) jeweils mehrere Unterzweige, von denen jeder einen Verstärker (9a - 12a; 9b - 12b) mit anderer vorgegebener Verstärkung enthält; und
(b) einen ersten Multiplexer (13a, 13b), der durch ein erstes (A, B) der digitalen Steuersignale steuerbar ist, um denjenigen Unterzweig auszuwählen, der den Verstärker mit der gewünschten Verstärkung enthält.

3. Schaltung nach Anspruch 2, bei der jeder der Zweige I und Q ferner eine jeweilige Dämpfungseinrichtung (14a, 14b) enthält, um Pfade mit verschiedenen Dämpfungen bereitzustellen, wobei einer der Pfade eine direkte Kopplung ergeben kann, und einen jeweiligen zweiten Multiplexer (15a, 15b) aufweist, wobei die Dämpfungseinrichtung zwischen den Ausgang des ersten Multiplexers und die Eingänge des zweiten Multiplexers geschaltet ist, wobei der letztere durch zweite (C, D, E) der digitalen Steuersignale steuerbar ist, für eine weitere schrittweise Einstellung der Verstärkung der Grundbandsignale I und Q.

4. Schaltung nach Anspruch 3, bei der die Dämpfungseinrichtung (14a, 14b) ein Widerstandsnetzwerk ist.

5. Schaltung nach einem der vorstehenden Ansprüche, bei der der HF-Verstärker zwei Verstärkungspegel aufweist und der gewünschte Pegel mittels eines dritten digitalen Steuersignals (F) auswählbar ist.

6. Schaltung nach Anspruch 5 in Abhängigkeit von Anspruch 3 oder Anspruch 4, bei der der gesamte Verstärkungsregelungsbereich des Empfängers Schritt für Schritt durch verschiedene Kombinationen der digitalen Steuersignale (A - F) überdeckt wird, die an den ersten und zweiten Multiplexer (13a, 13b; 15a, 15b) und den HF-Verstärker (2) angelegt werden.

## Revendications

1. Circuit pour récepteur d'un radiotéléphone numérique, ledit circuit comprenant :
un amplificateur RF (2) destiné à recevoir et à amplifier un signal RF
des moyens (3, 4, 5) comprenant au moins un mélangeur (3) destiné à transformer le signal RF amplifié en un signal de fréquence intermédiaire, et
une dérivation (6b, 7b, 8b, 16b) et une dérivation Q (6a, 7a, 8a, 16a), chacune étant couplée pour recevoir le signal intermédiaire afin de produire des signaux en bande de base I et Q respectivement,
caractérisé en ce qu'une première partie (9a à 15a ; 9b à 15b) d'un circuit de commande automatique de gain est incluse dans les dérivations I et Q pour réaliser la plus grande partie de la commande de gain total sur les signaux I et Q en bande de base, l'amplification des signaux I et Q en bande de base pouvant être commandée par paliers au moyen de signaux de commande numériques (A, B, C, D, E) et en ce qu'une seconde partie du circuit de commande automatique de gain est incluse dans l'amplificateur RF (2).

2. Circuit selon la revendication 1, dans lequel, pour former lesdits paliers d'amplification, chacune desdites dérivations I et Q comprend :
(a) une multitude respective de sous-dérivations, chacune comprenant un amplificateur (9a à 12a ; 9b à 12b) présentant un gain prédéterminé différent, et
(b) un premier multiplexeur (13a, 13b) qui peut être commandé par les premiers (A, B) desdits signaux de commande numériques afin de sélectionner la sous-dérivation contenant l'amplificateur présentant un gain désiré.

3. Circuit selon la revendication 2, dans lequel chacune desdites dérivations I et Q comprend en outre un atténuateur respectif (14a, 14b) procurant des trajets d'atténuation différents, dont un trajet peut permettre un couplage direct et un second multiplexeur respectif (15a, 15b), ledit atténuateur étant couplé entre la sortie dudit premier multiplexeur et des entrées dudit second multiplexeur, ce dernier pouvant être commandé par les seconds (C, D, E) desdits signaux de commande numériques pour une commande supplémentaire par paliers de l'amplification des signaux I et Q en bande de base.

4. Circuit selon la revendication 3, dans lequel ledit atténuateur (14a, 14b) est un réseau de résistances.

5. Circuit selon l'une quelconque des revendications précédentes, dans lequel l'amplificateur RF comporte deux niveaux d'amplification et dans lequel le niveau désiré peut être sélectionné au moyen d'un troisième signal de commande numérique (F).

6. Circuit selon la revendication 5 lorsquelle dépend de la revendication 3 ou 4, dans lequel la plage de commande de gain entière du récepteur est couverte palier par palier par différentes combinaisons des signaux de commande numériques (A à F) appliquées aux premier et second multiplexeurs (13a, 13b : 15a, 15b) et à l'amplificateur RF (2).
